# EUROPEAN PATENT APPLICATION

(11) **EP 4 138 098 A1**
(43) Date of publication of application: **22.02.2023**
(21) Application number: 21787972.5
(22) Date of filing: 13.01.2021
(51) Int. Cl.: H01B 13/00, H01B 5/14, H01B 1/02

(54) **CONDUCTIVE FILM AND PREPARATION METHOD THEREFOR**

(30) Priority: 13.04.2020 CN 202010287928; 13.04.2020 CN 202020542804 U
(71) Applicant: Shenzhen Hairun New Energy Technology Co., Ltd., Shenzhen, Guangdong 518057 (CN); Xiamen Hithium Energy Storage Technology Co., Ltd., Xiamen, Fujian 361006 (CN)
(72) Inventor: FENG, Junmin, Shenzhen, Guangdong 518000 (CN); ZHANG, Wancai, Shenzhen, Guangdong 518000 (CN); WU, Tingting, Shenzhen, Guangdong 518000 (CN)
(74) Representative: DREISS Patentanwälte PartG mbB
(86) International application number: PCT/CN2021/071607
(87) International publication number: WO 2021/208541

(57) **Abstract**

Provided are a conductive film and a preparation method for the same, which relate to the technical field of conductive films. The preparation method for the conductive film includes: forming a metal process layer on a surface of an insulating layer by means of evaporation deposition, wet electroplating or chemical plating; forming a metal transition layer on a surface of the metal process layer facing away from the insulating layer by means of magnetron sputtering; and forming a metal functional layer on a surface of the metal transition layer facing away from the metal process layer. The conductive film obtained by this preparation method can have relatively good conductivity and density while having a relatively thick metal conductive layer.

## Description

### CROSS-REFERENCE TO RELATED APPLICATIONS

This application claims priority to Chinese Patent Application No. 202010287928.8 entitled "Conductive Film and Preparation Method therefor" and Chinese Application No. 2020205428045 entitled "Conductive Film" filed before the China National Intellectual Property Administration on April 13, 2020, the entire contents of which are incorporated herein by reference.

### FIELD

The present disclosure relates to the technical field of conductive films, and in particular, to a conductive film and a preparation method therefor.

### BACKGROUND

In the related art, a composite conductive film includes an insulating layer (polymer substrate layer), and a first conductive layer and a second conductive layer respectively disposed on two surfaces of the insulating layer. In order to ensure the thickness of the first conductive layer and the second conductive layer, metal is usually deposited on the insulating layer multiple times using the same process, so as to obtain the first conductive layer and the second conductive layer with greater thicknesses. However, after the first conductive layer and the second conductive layer with greater thicknesses are formed, the first conductive layer and the second conductive layer usually have defects in density or conductivity.

### SUMMARY

An object of the present disclosure is to provide a conductive film and a preparation method for the same, which enable relatively good density and conductivity of the conductive film while ensuring the thickness of the metal conductive layer.

Another object of the present disclosure is to provide a composite conductive film material and a preparation method therefor, aiming at improving the density and conductivity of the composite conductive film material.

In a first aspect, an embodiment of the present disclosure provides a preparation method for a conductive film. The method includes the following steps: forming a metal process layer on a surface of an insulating layer by means of evaporation deposition, wet electroplating or chemical plating; forming a metal transition layer on a surface of the metal process layer facing away from the insulating layer by means of magnetron sputtering; and forming a metal functional layer on a surface of the metal transition layer facing away from the metal process layer.

Since the metal process layer is prepared by evaporation deposition, wet electroplating or chemical plating, the metal process layer can be quickly accumulated to a certain thickness. The efficiency is high, and the obtained metal process layer has good conductivity, and can be used as a deposition substrate for forming the metal transition layer. Then the metal transition layer is obtained by magnetron sputtering. The deposition method of magnetron sputtering is a cold deposition method, which can make the dispersibility in the metal transition layer better and the surface of the metal transition layer more uniform, and make the metal transition layer have a better density and no crack. Thus, the subsequent functional layer has a higher density and better uniformity, so as to obtain a conductive film with a thicker metal conductive layer and better density and conductivity.

In a possible embodiment, the metal functional layer is formed on the surface of the metal transition layer facing away from the metal process layer by means of wet electroplating.

The metal functional layer formed by wet electroplating has a good conductivity and density. When the metal functional layer is formed by wet electroplating, the polymer substrate film with the metal process layer and the metal transition layer formed thereon is used as a substrate material for wet electroplating. In addition to having a good electrical conductivity, the substrate material has the metal transition layer with a good density as the basis for wet electroplating, which can make the formed metal functional layer also have a good density, so as to obtain the metal functional layer with better density and conductivity.

In a possible embodiment, before forming the metal process layer, the insulating layer is preprocessed to make the insulating layer have a moisture content less than 1000 ppm. The preprocessing can be performed by baking. By further controlling the moisture content of the insulating layer, the bonding performance between the insulating layer and the metal process layer can be improved, the possibility for the metal process layer to be peeled off can be reduced or even eliminated, and the bonding effect of the entire conductive film can be improved.

In a second aspect, the present disclosure provides a conductive film prepared by the above-mentioned preparation method for the conductive film. With the optimized preparation process, the density of the conductive film can be made to be more than 60%, thus achieving the effect of significantly improving the density of the conductive film.

In the conductive film prepared by the above method, the metal functional layer mainly plays a conductive role, and the metal functional layer has a higher density and better uniformity, so as to obtain a conductive film with a better density and conductivity.

The metal process layer, the metal transition layer and the metal functional layer are not limited. The metal process layer is at least one selected from a copper metal layer, a nickel metal layer, an aluminum metal layer, a titanium metal layer, or an alloy layer; the metal transition layer is at least one selected from a copper metal layer, a nickel metal layer, an aluminum metal layer, a titanium metal layer, or an alloy layer; and the metal functional layer is at least one selected from a copper metal layer, a nickel metal layer, an aluminum metal layer, a titanium metal layer, or an alloy layer.

In a possible embodiment, the metal process layer, the metal transition layer and the metal functional layer are all copper layers. Optionally, the metal process layer has a thickness between 2 nm and 100 nm, the metal transition layer has a thickness between 5 nm and 50 nm, and the metal functional layer has a thickness between 30 nm and 2500 nm. Optionally, the thickness of the metal functional layer is between 300 nm and 1500 nm.

The metal process layer, the metal transition layer and the metal functional layer are all made of the same metal and are prepared by different processes. When the metal transition layer is thin, the metal functional layer can have a good density performance, so as to improve the performance of the conductive film.

In a possible embodiment, the conductive film further includes a bonding layer, and the bonding layer is disposed between the insulating layer and the metal process layer.

The bonding layer arranged can have a certain bonding effect, and cooperates with the control of the moisture content of the insulating layer to have a certain synergistic effect, which can effectively improve the bonding force between the metal process layer and the insulating layer, and further avoid the peeling of the metal process layer, to make the bonding effect of the entire conductive film better.

In a possible embodiment, the bonding layer has a thickness between 2 nm and 40 nm. The bonding layer is a metal material layer, which includes one or more of a Ti metal layer, a W metal layer, a Cr metal layer, a Ni metal layer, a Cu metal layer, or an alloy layer thereof.

The bonding force between the layers of the entire conductive film can be made better, while ensuring the density of the functional layer.

In a possible embodiment, the conductive film further includes a protective layer. The protective layer is disposed on a surface of the metal functional layer facing away from the metal transition layer. It can protect the metal functional layer, prevent the metal functional layer from being oxidized or even falling off, and prevent the metal functional layer from being damaged.

In a possible embodiment, the protective layer has a thickness between 0.1nm and 100 nm. Optionally, the protective layer is a conductive non-metallic protective layer or an inert metal protective layer, which can well protect the metal functional layer.

In a third aspect, an embodiment of the present disclosure provides a composite conductive film material, which includes an insulating layer and a conductive layer disposed on a surface of the insulating layer. The conductive layer is the above-mentioned conductive film.

Optionally, the insulating layer has a moisture content smaller than 1000 ppm.

In the related art, a composite conductive film generally includes an insulating layer (polymer substrate layer) and a first conductive layer and a second conductive layer respectively disposed on two surfaces of the insulating layer. The inventors found that when the composite conductive film is being used, the conductive layer may be wrinkled on the insulating layer, and problems such as peeling may occur. After research, the inventors found that controlling the moisture content of the insulating layer to be less than 1000 ppm can effectively improve the bonding force between the insulating layer and the conductive layer in the conductive film, mitigate the peeling problem of the conductive layer, and make the performance of the conductive film more excellent.

In a possible embodiment, a bonding layer is further included, and the bonding layer is disposed between the insulating layer and the conductive layer. Optionally, the bonding layer has a thickness between 2 nm and 40 nm. Optionally, the bonding layer is a metal material layer, which includes one or more of a Ti metal layer, a W metal layer, a Cr metal layer, a Ni metal layer, a Cu metal layer, or an alloy layer thereof.

The arranged bonding layer cooperates with the insulating layer having the moisture content smaller than 1000 ppm, which can multiply the bonding force between the insulating layer and the conductive layer in the conductive film, and obtain a conductive film with better bonding effect.

In a fourth aspect, an embodiment of the present disclosure provides a preparation method for a composite conductive film material, which is used to prepare and form the above-mentioned composite conductive film material.

Optionally, before forming the metal process layer, the insulating layer is preprocessed to make the insulating layer have a moisture content smaller than 1000 ppm. The prepocessing can be performed by baking. After the conductive layer is formed on the insulating layer with controlled moisture content, the bonding force between the insulating layer and the conductive layer in the obtained conductive film can mitigate the problem of peeling off of the conductive layer and make the performance of the conductive film more excellent.

### BRIEF DESCRIPTION OF DRAWINGS

In order to clearly explain technical solutions of embodiments of the present disclosure, drawings used in the embodiments are briefly described below. Obviously, the drawings as described below are merely some embodiments of the present disclosure and therefore should not be regarded as a limitation on the scope. Based on these drawings, other drawings can be obtained by those skilled in the art without inventive effort, and they also belong to the protection scope of the present disclosure.
FIG. 1 is a schematic structural diagram of a conductive composite film material according to an embodiment of the present disclosure.
FIG. 2 shows scanning force microscope images of conductive films.
FIG. 3 shows scanning electron microscope images of conductive films.
FIG. 4 shows dark field images of conductive films.
FIG. 5 shows bright field images of conductive films.
FIG. 6 shows photographs of finished products of conductive films.

Reference numbers: 110-insulating layer; 120-bonding layer; 130-metal process layer; 140-metal transition layer; 150-metal functional layer; 160-protective layer.

### DESCRIPTION OF EMBODIMENTS

In order to make the objects, technical solutions and advantages of the embodiments of the present disclosure clearer, the technical solutions in the embodiments of the present disclosure will be described below with reference to the accompanying drawings in the embodiments of the present disclosure.

The inventors found that, in the related art, the same process is usually used to deposit a metal conductive layer on the insulating layer. If a thicker metal conductive layer is desired, it is usually obtained by single or multiple depositions using the same process. For example, if a metal conductive layer is formed on the surface of the insulating layer by evaporation deposition which is a thermal deposition method, the metal conductive layer can be quickly accumulated to a certain thickness, with a high efficiency and a good conductivity. However, the metal conductive layer obtained by the evaporation deposition method is not uniform, has poor toughness and a low strength, and will lead to a certain degree of deformation of the film. For example, alkaline electroplating, as an electrochemical deposition process, can quickly accumulate a metal conductive layer to a certain thickness, with a high efficiency and a good conductivity. However, the conductive layer obtained by alkaline electroplating has a poor density.

If magnetron sputtering is used to form a metal conductive layer on the surface of the insulating layer, then since magnetron sputtering is a cold deposition method, no significant heat will be generated during the deposition process, and the formed metal conductive layer has a sheet-like structure with a good dispersibility and a good density. However, since it is formed in principle under the action of the plasma magnetic field, new impurities (for example, noble gas molecules) will be introduced, resulting in a low purity and a poor conductivity of the metal conductive layer.

If the metal conductive layer is formed by wet electroplating, the substrate must have a certain conductive property. For example, a metal conductive layer is formed on a conductive polymer layer by wet electroplating, so as to obtain a film with a conductive polymer layer in the middle and a metal conductive layer on each of both surfaces. However, the conductivity of conductive polymer is worse than that of metal, so the conductivity of the conductive polymer substrate may be insufficient, so that the performance of the metal conductive layer formed by wet electroplating is not good.

The inventor also found that if a metal conductive layer is formed on the insulating layer by evaporation deposition before a thickened metal conductive layer is further formed on the metal conductive layer by wet electroplating, then due to the nonuniformity and poor toughness of the metal conductive layer formed by the evaporation deposition, when the metal conductive layer is further thickened by wet electroplating, the thickened metal conductive layer will also have defects of nonuniformity, a poor toughness and a poor density.

If a metal conductive layer is formed on the metal insulating layer by magnetron sputtering before a thickened metal conductive layer is further formed on the metal conductive layer by wet electroplating, then since the metal conductive layer formed by magnetron sputtering contains impurities, has poor purity and conductivity and is non-uniform, the conductivity of the substrate is poor (non-uniform conductivity) in the process of wet electroplating, which will cause the thickened metal conductive layer to be non-uniform, and make it impossible to obtain a thicker metal conductive layer.

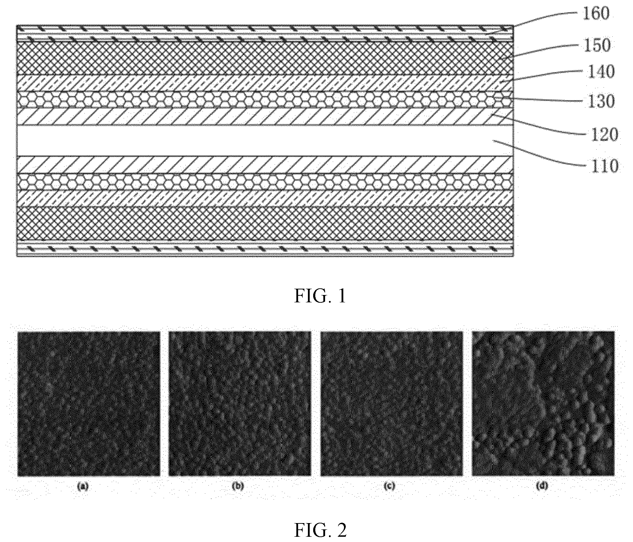

Therefore, in view of the above problems, the inventor provides a preparation method for a conductive film. FIG. 1 is a schematic structural diagram of a conductive composite film material provided by the present disclosure. It is prepared by the following preparation method for the conductive composite film material. Referring to FIG. 1, the preparation method for the conductive composite film material in FIG. 1 is as follows.

At S10, an insulating layer 110 is selected; that is, a substrate layer is selected. In the present disclosure, the material of the substrate layer can be one of OPP (O-phenylphenol), PET (Polyethylene terephthalate), PI (Polyimide), PS (Polystyrene), PPS (Polyphenylenesulphide), CPP (Cast polypropylene), PEN (Polyethylene naphthalate two formic acid glycol ester), PVC (Polyvinyl chloride), PEEK (Poly(ether-ether-ketone)), PES (Polyethersulfone resin), PPSU (Polyphenylene sulfone resins), PE (Polyethylene), non-woven fabric.

Optionally, the thickness of the substrate layer is between 1.2 µ m and 12 µm. Further, the thickness of the substrate layer is between 1.2 µm and 6 µm. For example, the thickness of the substrate layer is 1.2 µm, 1.5 µm, 2 µm, 4 µm, 8 µm, or 12 µm.

At S20, the insulating layer 110 is baked. After baking, the moisture content of the insulating layer 110 is reduced, and the moisture content of the insulating layer is smaller than 1000 ppm, which can improve the bonding performance between the insulating layer 110 and a metal process layer 130 formed subsequently, can reduce or even eliminate the possibility for the metal process layer 130 to be peeled off, and improve the bonding performance of the entire conductive film.

By taking PET film and PP film as examples, the moisture contents of the films before and after baking are shown in Table 1 and Table 2 as follows.

**Table 1 Moisture content of PET film**

| Film running speed m/min | Average moisture content/ppm | | | |
|---|---|---|---|---|
| | Original film | Control temperature/60°C | Control temperature/90°C | Control temperature/120°C |
| 10 | 2173.00 | 1705.00 | 484.00 | 438.67 |
| 40 | 2173.00 | 1419.00 | 1008.33 | 692.67 |
| 80 | 2173.00 | 1650.00 | 1650.00 | 666.00 |

**Table 2 Moisture content of PP film**

| Film running speed m/min | Average moisture content/ppm | | | |
|---|---|---|---|---|
| | Original film | Control temperature/60°C | Control temperature/80°C | Control temperature/100°C |
| 10 | 2152.00 | 1328.33 | 1046.00 | 238.33 |
| 40 | 2152.00 | 1123.00 | 1278.33 | 332.50 |
| 80 | 2152.00 | 1315.33 | 1315.33 | 375.67 |

It can be seen from Table 1 and Table 2 that after baking, the moisture content of the insulating layer 110 can be greatly reduced, and the degree of reduction of the moisture content is related to both the film running speed and the baking temperature.

In other embodiments, the moisture content of the insulating layer 110 may not be controlled.

At S30, a bonding layer 120 is formed on a surface of the insulating layer 110. The formation of the bonding layer 120 cooperates with the control of the moisture content of the insulating layer 110 (moisture content smaller than 1000 ppm) to have a certain synergistic effect, which can effectively improve the bonding force between the subsequently formed metal process layer 130 and the insulating layer 110, further avoiding the peeling of the metal process layer 130, and make the bonding effect of the entire conductive film better.

Optionally, the thickness of the bonding layer 120 is between 2 nm and 40 nm. For example, the thickness of the bonding layer 120 is 2 nm, 10 nm, 15 nm, 20 nm, 30 nm, or 40 nm. Here, the bonding layer 120 may be formed on one surface of the insulating layer 110, or the bonding layer 120 may be formed on each of both surfaces of the insulating layer 110, which is not limited in the embodiment of the present disclosure. The formation of the bonding layer 120 can be controlled based on whether the target conductive film has one conductive surface or two conductive surfaces. In other embodiments, the bonding layer 120 may not be provided.

The bonding layer 120 may be a metal material layer, which may be one or more of a Ti metal layer, a W metal layer, a Cr metal layer, a Ni metal layer, a Cu metal layer, or an alloy layer thereof. The bonding force between the layers of the entire conductive film can be made better, while ensuring the density of the functional layer.

For example, the bonding layer 120 may be a Ti metal layer, the bonding layer 120 may be a W metal layer, the bonding layer 120 may be a Ni metal layer, the bonding layer 120 may be a Cu metal layer, the bonding layer 120 may be a Ti alloy layer, the bonding layer 120 may be a W alloy layer, the bonding layer 120 may be a Ni alloy layer, the bonding layer 120 may be a Cu alloy layer, or the like.

In the embodiment of the present disclosure, the metal material layer may be of one type or multiple types. For example, it may be a pure metal layer; it may also be an alloy layer; it is also possible to form a metal layer first, and then form another metal layer; it is also possible to form a metal layer first, and then form an alloy layer; or the like. The embodiments of the present disclosure are not limited.

Optionally, the method of forming the bonding layer 120 may be an evaporation deposition method, or a magnetron sputtering method, which is not limited in the embodiment of the present disclosure.

At S40, the metal process layer 130 is formed on a surface of the insulating layer 110 by means of evaporation deposition, wet electroplating or chemical plating, so that the metal process layer 130 can be quickly accumulated to a certain thickness, and the efficiency is high. The obtained metal process layer 130 has a good conductivity, and can be used as a deposition substrate for the subsequent formation of a metal transition layer 140.

If no bonding layer 120 is formed on the surface of the insulating layer 110, the metal process layer 130 is formed on the surface of the insulating layer 110 by means of evaporation deposition, wet electroplating or chemical plating. The metal process layer 130 may be formed on one surface, or the metal process layer 130 may be formed on each of both surfaces. The embodiment of the present disclosure is not limited. The formation of the metal process layer 130 may be controlled based on whether the target conductive film is conductive on one surface or on each of both surfaces.

If the bonding layer 120 is formed on the surface of the insulating layer 110, the metal process layer 130 is formed on the surface of the bonding layer 120 by means of evaporation deposition, wet electroplating or chemical plating.

The metal process layer 130 may be a copper metal layer, a nickel metal layer, an aluminum metal layer, a titanium metal layer, an alloy layer thereof, etc., which is not limited in the embodiment of the present disclosure. If the metal process layer 130 is a copper metal layer, the production cost of the conductive film can be greatly reduced while ensuring better conductivity.

Optionally, the thickness of the metal process layer 130 is between 2 nm and 100 nm. Further, the thickness of the metal process layer 130 is between 20 nm and 50 nm. For example, the thickness of the metal process layer 130 may be 2 nm, 15 nm, 20 nm, 40 nm, 50 nm, 60 nm, or 100 nm.

At S50, the metal transition layer 140 is formed on a surface of the metal process layer 130 away from the insulating layer 110 by means of magnetron sputtering. This can make the dispersibility in the metal transition layer 140 better and the surface of the metal transition layer 140 more uniform, and make the metal transition layer 140 have a better density and no crack, so that a metal functional layer 150 with better density and conductivity can be formed later.

The metal transition layer 140 may be a copper metal layer, a nickel metal layer, an aluminum metal layer, a titanium metal layer, an alloy layer thereof, etc., which is not limited in the embodiment of the present disclosure. If the metal transition layer 140 is a copper metal layer, the production cost of the conductive film can be greatly reduced while ensuring better conductivity.

Optionally, the thickness of the metal transition layer 140 is between 5 nm and 50 nm. Further, the thickness of the metal transition layer 140 is between 8 nm and 30 nm. For example, the thickness of the metal transition layer 140 may be 5 nm, 8 nm, 10 nm, 15 nm, 20 nm, or 50 nm.

At S60, the metal functional layer 150 is formed on a surface of the metal transition layer 140 away from the metal process layer 130. Since the metal transition layer 140 has better density, forming the metal functional layer 150 on the basis of the metal transition layer 140 can make the obtained metal functional layer 150 have higher density and better uniformity, so as to obtain a conductive film with excellent performance.

The metal functional layer 150 may be a copper metal layer, a nickel metal layer, an aluminum metal layer, a titanium metal layer, an alloy layer thereof, etc., which is not limited in the embodiment of the present disclosure. If the metal functional layer 150 is a copper metal layer, the production cost of the conductive film can be greatly reduced while ensuring better conductivity.

Optionally, the thickness of the metal functional layer 150 is between 30 nm and 2500 nm. Further, the thickness of the metal functional layer 150 is between 300 nm and 1500 nm. Further, the thickness of the metal functional layer 150 is between 500 nm and 1000 nm. For example, the thickness of the metal functional layer 150 may be 30 nm, 100 nm, 500 nm, 800 nm, 1000 nm, 2000 nm, or 2500 nm.

Optionally, the metal functional layer 150 is formed on the surface of the metal transition layer 140 away from the metal process layer 130 by means of wet electroplating. Since the electrical conductivity of the metal process layer 130 is good and the density of the metal transition layer 140 is good, a polymer substrate film with the metal process layer 130 and the metal transition layer 140 formed thereon is used as a substrate material for wet electroplating, when the metal functional layer 150 is formed by wet electroplating. In addition to having good electrical conductivity, the substrate material has the metal transition layer 140 with good density as the basis for wet electroplating, which can make the formed metal functional layer 150 also has a good density. In addition, the metal functional layer 150 formed by wet electroplating has a higher purity, and a thicker metal functional layer 150 can be obtained. Thus, a thicker metal functional layer 150 with better density and conductivity can be obtained.

In other embodiments, the metal functional layer 150 may also be formed on the surface of the metal transition layer 140 by means of evaporation deposition or nano-spraying. Optionally, the metal process layer 130, the metal transition layer 140 and the metal functional layer 150 are all of the same metal, or may be of different types of metal. If the metal process layer 130, the metal transition layer 140 and the metal functional layer 150 are all of the same metal and are prepared by different processes, the metal functional layer 150 can have a good density, a high thickness, and a good purity when the metal transition layer 140 is thin, so as to improve the performance of the conductive film.

At S70, a protective layer 160 is formed on a surface of the metal functional layer 150 away from the metal transition layer 140. The protective layer can protect the metal functional layer 150, prevent the metal functional layer 150 from being oxidized or even falling off, and prevent the metal functional layer 150 from being damaged.

In the embodiment of the present disclosure, the formation method of the protective layer 160 is not limited. The protective layer 160 is a conductive non-metallic protective layer or an inert metal protective layer. Optionally, the thickness of the protective layer 160 is between 0.1 nm and 100 nm. Further, the thickness of the protective layer 160 is between 10 nm and 50 nm. For example, the thickness of the protective layer 160 is 0.1 nm, 2 nm, 10 nm, 30 nm, 50 nm, 80 nm, or 100 nm.

If the protective layer 160 is an inert metal protective layer, the metal of the inert metal protective layer is one of Cr, Ni, Ni alloy, and Cr alloy. For example, the protective layer 160 can be a Cr layer; the protective layer 160 can be a Ni layer; the protective layer 160 can be a Ni alloy layer; or the protective layer 160 can be a Cr alloy layer. If the protective layer 160 is a conductive non-metallic protective layer, the protective layer 160 can be a glucose complex layer; or the protective layer 160 can also be a potassium dichromate layer.

The conductive film formed by the above preparation method includes an insulating layer 110, and a bonding layer 120 and a conductive layer sequentially disposed on the surface of the insulating layer 110. The conductive layer includes the above-mentioned metal process layer 130, the above-mentioned metal transition layer 140, the above-mentioned metal functional layer 150 and the above-mentioned protective layer 160 arranged in sequence. The metal process layer 130 adheres to the bonding layer 120. It should be noted that the conductive film may or may not have the bonding layer 120; and the conductive layer may include one or more of the metal process layer 130, the metal transition layer 140 and the metal functional layer 150 in addition to the protective layer.

In the above conductive film, the metal functional layer 150 mainly plays a conductive role, which has a good density (density greater than 60%), a high purity, a good conductivity and a uniform thickness. In addition, the bonding force between the layers of the conductive film is better, and the peeling of the layer structure of the conductive film can be reduced or even eliminated.

### Embodiment 1

This embodiment provides a preparation method for a conductive composite film material, including the following steps.

A copper process layer with a thickness of about 21 nm is formed on each of both surfaces of a PP insulating layer with a thickness of about 2 µm and a moisture content of about 2152 ppm by evaporation deposition. A copper transition layer with a thickness of about 12 nm is formed on the surface of each of the two copper process layers by magnetron sputtering. A copper functional layer with a thickness of about 1031 nm is formed on the surface of each of the two copper transition layers by wet electroplating. A chromium protection layer 160 with a thickness of about 32 nm is formed on the surface of each of the two functional layers by wet electroplating.

The process parameters of the evaporation deposition are as follows. The coil material is put into the vacuum chamber of the vacuum evaporation deposition machine, the vacuum chamber is sealed and vacuumized step by step until the vacuum degree reaches 2× 10⁻² Pa. The crucible high-frequency heating method, the resistance heating method or the electron beam heating method is used as the evaporation source, the evaporation raw material for the evaporation source is metal copper with a purity greater than 99.9%, the winding speed is controlled at 200 m/min, and evaporated atoms or molecules are formed into a deposition layer on the surface of the functional layer.

The process parameters of magnetron sputtering are as follows. The coil material is put into the vacuum chamber of the vacuum magnetron sputtering deposition machine, the vacuum chamber is sealed and vacuumized step by step until the vacuum degree reaches 7×10⁻³ Pa. Then, Ar gas is fed in as a process sputtering gas, and the rate of the Ar flow is controlled at 800 SCCM. Magnetron sputtering is used to perform film deposition on the film surface functional layer, the target material is nickel, chromium, nickel alloy, or chromium alloy with a purity greater than 99.99%, the winding speed is controlled at 40 m/min, and the sputtered ions form a magnetron sputtering deposition layer on the surface of the functional layer.

The process parameters of wet electroplating are as follows. The coil material is put on the unwinding machine of the wet electroplating line and is run by pulling the film, the internal microcirculation is gradually turned up to 9 times/hour, the solution temperature is 25 ± 3 °C, the cooling water temperature is 20±2 °C. The solution composition is as follows: copper sulfate concentration is 80 g/L, Cl concentration is 45 ppm, additive concentration is 300ml/1000Ah, and sulfuric acid concentration is 170 g/L. Then, the current is applied on each conductive roller according to the film, the total current applied is 8500 A, the film deposition speed is 5 m/min. The film carries negative charges, and each copper ion in the solution receives 2 electrons on the surface of the film and is reduced to a copper element, so that a copper layer is formed on the surface of the film.

The specific process parameters of other embodiments and comparative examples are consistent with the process parameters provided above.

### Embodiment 2

This embodiment provides a preparation method for a conductive composite film material, including the following steps.

A PP insulating layer with a thickness of about 2 µm is dried at a temperature of 100 °C, so that the moisture content of the insulating layer is about 332.5 ppm. A copper process layer with a thickness of about 20 nm is formed on each of the two surfaces of an OPP insulating layer by evaporation deposition. A copper transition layer with a thickness of about 13 nm is formed on the surface of each of the two copper process layers by magnetron sputtering. A copper functional layer with a thickness of about 1033 nm is formed on the surfaces of each of the two copper transition layers by wet electroplating. A chromium protective layer 160 with a thickness of about 30 nm is formed on the surface of each of the two functional layers by wet electroplating.

### Embodiment 3

This embodiment provides a preparation method for a conductive composite film material, including the following steps.

A copper process layer with a thickness of about 22 nm is formed on each of both surfaces of a PP insulating layer with a thickness of about 2 µm and a moisture content of about 2152 ppm by means of evaporation deposition. A copper transition layer with a layer thickness of about 11nm is formed on the surface of each of the two copper process layers by magnetron sputtering. A copper functional layer with a thickness of about 1035 nm is formed on the surface of each of the two copper transition layers by evaporation deposition. A chromium protection layer 160 with a thickness of about 35 nm is formed on the surface of each of the two functional layers by wet electroplating.

### Embodiment 4

This embodiment provides a preparation method for a conductive composite film material, including the following steps. A copper process layer with a thickness of about 20 nm is formed on each of both surfaces of a PP insulating layer with a thickness of about 2 µm and a moisture content of about 2152 ppm by wet electroplating. A copper transition layer with a thickness of about 19 nm is formed on the surface of each of the two copper process layers by magnetron sputtering. A copper functional layer with a thickness of about 1034 nm is formed on the surface of each of the two copper transition layers by means of evaporation deposition. A chromium protective layer 160 with a thickness of about 33 nm is formed on the surface of each of the two functional layers by wet electroplating.

### Embodiment 5

This embodiment provides a preparation method for a conductive composite film material, including the following steps. A copper process layer with a thickness of about 21 nm is formed on each of both surfaces of a PP insulating layer with a thickness of about 2 µm and a moisture content of about 2152 ppm by means of evaporation deposition. A copper transition layer with a thickness of about 6 nm is formed on the surface of each of the two copper process layers by magnetron sputtering. A copper functional layer with a thickness of about 1031 nm is formed on the surface of each of the two copper transition layers by wet electroplating. A chromium protective layer 160 with a thickness of about 34 nm is formed on the surface of each of the two functional layers by means of wet electroplating.

### Embodiment 6

This embodiment provides a preparation method for a conductive composite film material, including the following steps.

A PP insulating layer with a thickness of about 2 µm is dried at a temperature of 100 °C, so that the moisture content of the insulating layer is about 332.5 ppm. A nickel bonding layer 120 with a thickness of about 15 nm is formed on each of both surfaces of an OPP insulating layer by magnetron sputtering. A copper process layer with a thickness of about 24 nm is formed on the surface of each of the two nickel bonding layers 120 by evaporation deposition. A copper transition layer with a thickness of about 14nm is formed on the surface of each of the two copper process layers by magnetron sputtering. A copper functional layer with a thickness of about 1041 nm is formed on the surface of each of the two copper transition layers by wet electroplating. A chromium protective layer 160 with a thickness of about 31 nm is formed on the surface of each of the two functional layers by means of wet electroplating.

### Embodiment 7

This embodiment provides a preparation method for a conductive composite film material, which includes the following steps. A PP insulating layer with a thickness of about 2 µm is dried at 100°C, so that the moisture content of the insulating layer is about 332.5 ppm. A copper bonding layer 120 with a thickness of about 14 nm is formed on each of the two surfaces of an OPP insulating layer by magnetron sputtering. A copper process layer with a thickness of about 23 nm is formed on the surface of each of the two nickel bonding layers 120 by evaporation deposition. A copper transition layer with a thickness of about 13nm is formed on the surface of each of the two copper process layers by magnetron sputtering. A copper functional layer with a thickness of about 1040 nm is formed on the surface of each of the two copper transition layers by wet electroplating. A chromium protective layer 160 with a thickness of about 32 nm is formed on the surface of each of the two functional layers by means of wet electroplating.

### Embodiment 8

This embodiment provides a preparation method for a conductive composite film material, including the following steps. A copper bonding layer 120 with a thickness of about 13 nm is formed on each of both surfaces of a PP insulating layer with a thickness of about 2 µm and a moisture content of about 2152 ppm by magnetron sputtering. A copper process layer with a thickness of about 22 nm is formed on the surface of each of the two nickel bonding layers 120 by means of evaporation deposition. A copper transition layer with a thickness of about 15nm is formed on the surface of each of the two copper process layers by means of magnetron sputtering. A copper functional layer with a thickness of about 1046 nm is formed on the surface of each of the two copper transition layers by wet electroplating. A chromium protective layer 160 with a thickness of about 29 nm is formed on the surface of each of the two functional layers by wet electroplating.

### Comparative Example 1

This comparative example provides a preparation method for a conductive composite film material, including the following steps.

A copper process layer with a thickness of about 25 nm is formed on each of both surfaces of a PP insulating layer with a thickness of about 2µm and a moisture content of about 2152 ppm by means of evaporation deposition. A copper functional layer with a thickness of about 1039 nm is formed on the surface of each of the two copper transition layers by wet electroplating. A chromium protective layer 160 with a thickness of about 33 nm is formed on the surface of each of the two functional layers by wet electroplating.

### Comparative Example 2

This comparative example provides a preparation method for a conductive composite film material, which includes the following steps. A copper transition layer with a thickness of about 11 nm is formed on each of both surfaces of a PP insulating layer with a thickness of about 2µm and a moisture content of about 2152 ppm by magnetron sputtering. A copper functional layer with a thickness of about 1042 nm is formed on the surface of each of the two copper transition layers by wet electroplating. A chromium protective layer 160 with a thickness of about 34 nm is formed on the surface of each of the two functional layers by wet electroplating.

### Experimental example 1

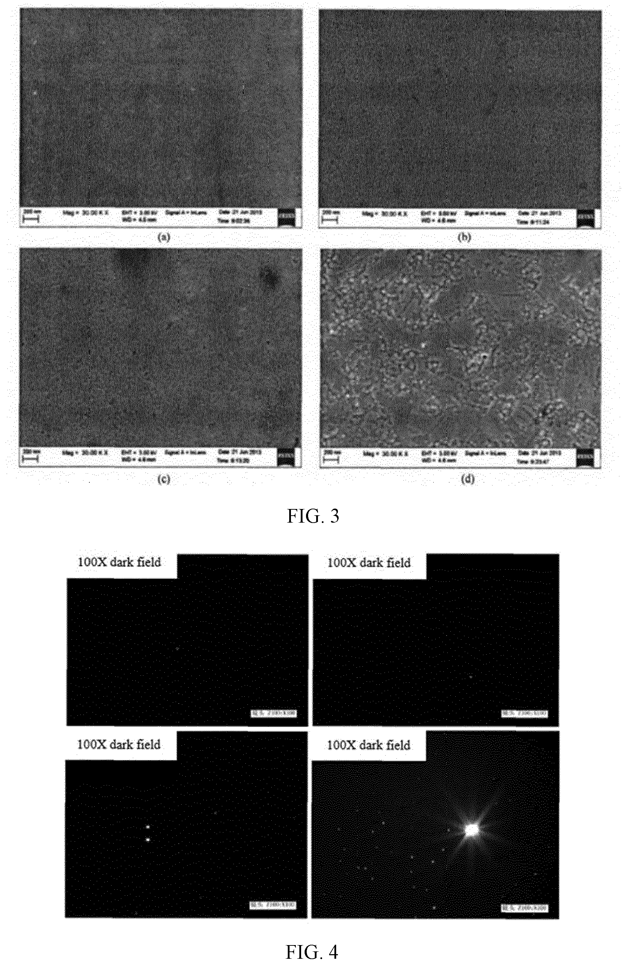

Scanning force microscope (SFM) and scanning electron microscope (SEM) are used to detect the surface morphology of the composite conductive film materials prepared in Embodiments 1, 4 and 5 and the composite conductive film material prepared in Comparative Example 1. FIG. 2 shows scanning force microscope images of composite conductive film materials. FIG. 2 (a) is a scanning force microscope image of a composite conductive film material prepared in Embodiment 4, FIG. 2 (b) is a scanning force microscope image of a composite conductive film material prepared in Embodiment 1, FIG. 2 (c) is a scanning force microscope image of a composite conductive film material prepared in Embodiment 5, and FIG. 2 (d) is a scanning force microscope image of a composite conductive film material prepared in Comparative Example 1. FIG. 3 shows scanning electron microscope images of composite conductive film materials. FIG. 3 (a) is a scanning electron microscope image of a composite conductive film material prepared in Embodiment 4, Fig. 3 (b) is a scanning electron microscope image of a composite conductive film material prepared in Embodiment 1, Fig. 3 (c) is a scanning electron microscope image of a composite conductive film material prepared in Embodiment 5, and Fig. 3 (d) is a scanning electron microscope image of a composite conductive film material prepared in Comparative Example 1. It can be seen from FIG. 2 and FIG. 3 that the conductive films of Embodiments 1, 4 and 5 each have a copper transition layer with a surface morphology having uniform granularity, almost uniform unevenness, close arrangement, good density, and no crack. And the copper transition layer has a thickness between 10 nm and 20 nm, and has a better surface morphology. The conductive film of Comparative Example 1 has no copper transition layer, and its surface morphology has non-uniform granularity, and has defects such as cracks and non-uniform unevenness.

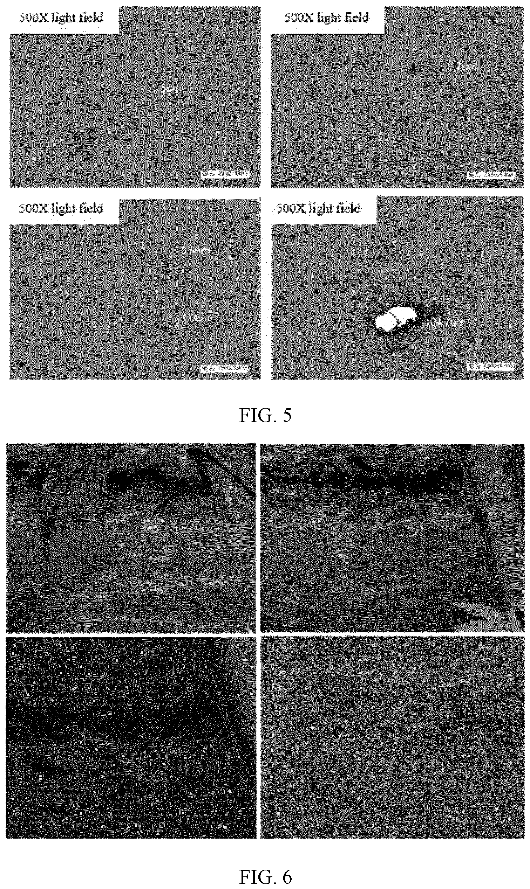

The light transmittance of the composite conductive film materials prepared in Embodiments 1, 4 and 5 and the composite conductive film material prepared in Comparative Example 1 are tested. FIG. 4 shows dark field images of composite conductive film materials. The upper left corner of FIG. 4 is a dark field image of a composite conductive film material prepared in Embodiment 4, the upper right corner of FIG. 4 is a dark field image of a composite conductive film material prepared in Embodiment 1, the lower left corner of FIG. 4 is a dark field image of a composite conductive film material prepared in Embodiment 5, and the lower right corner of FIG. 4 is a dark field image of a composite conductive film material prepared in Comparative Example 1. FIG. 5 shows bright field images of conductive films. The upper left corner of FIG. 5 is a bright field image of a composite conductive film material prepared in Embodiment 4, the lower right corner of FIG. 5 is a bright field image of a composite conductive film material prepared in Embodiment 1, the lower left corner of FIG. 5 is a bright field image of a composite conductive film material prepared in Embodiment 5, and the lower right corner of FIG. 5 is a bright field image of a composite conductive film material prepared in Comparative Example 1. Both the bright field image and the dark field image are taken by microscope. In the bright field image, the background is bright and the target is dark; in the dark field image, the background is dark and the target is bright. FIG. 6 shows photographs of finished products of composite conductive film materials, and the photographs of the conductive films are taken with a color-uniform flat panel lamp of 300 lumens and a focal length of 200 mm. The upper left corner of FIG. 6 is a photograph of a finished product of a composite conductive film material prepared in Embodiment 4, the lower right corner of FIG. 6 is a photograph of a finished product of a composite conductive film material prepared in Embodiment 1, the lower left corner of FIG. 6 is a photograph of a finished product of a composite conductive film material prepared in Embodiment 5, and the lower right corner of FIG. 6 is a photograph of a finished product of a composite conductive film material prepared in Comparative Example 1. It should be noted that the large hole in the pictures in the lower right corner of FIG. 4 and in the lower right corner in FIG. 5 is a defect hole in the film itself, and is not used as a basis for evaluating light transmission and its density. There is a certain difference between the positions of the samples selected in FIG. 6 and the positions of the samples selected in FIG. 4 or FIG. 5. Other small holes in the figures can suggest that there is light passing through, and the reason may be that the formed copper layer is not uniform, loose, and the density is not good. It can be seen from FIG. 4, FIG. 5 and FIG. 6 that the conductive films of Embodiments 1, 4 and 5 each have a copper transition layer, which is less likely to transmit light, has better uniformity and better density. And the thickness of the copper transition layer is between 10 nm and 20 nm, and the density is better. The composite conductive film material of Comparative Example 1 has no copper transition layer, and has large light transmission holes and poor density.

### Experimental example 2

The bonding forces and densities of the composite conductive film materials provided in Embodiments 1 to 8 and Comparative Examples 1 and 2 are tested, and the production costs of different types of composite conductive film materials (the basic cost is A, and other costs are expressed as coefficients multiplied with A) are compared to obtain Table 3.

The test method for density is as follows: (1) In a fixed test environment, under the backlight source, an illuminometer is used to test the illuminance at the fixed position, which is denoted as A; (2) As with step (1), illuminance value is tested with a completely opaque board covering the backlight plate, and is denoted as B; (3) The film to be tested is placed on the backlight plate, and the illuminance meter value is read and is denoted as C; (4) the density is calculated as : 1-(C-B)/(A-B).

The test method for bonding force is as follows: (1) With a fixed type of 3M tape, the fixed pressure roller presses the film surface firmly; (2) On the tension machine, it is pulled in the opposite parallel direction, i.e. at an angle of 180° . Among the bonding force data, different pulling speeds are tested. On the premise that the surface layer is not peeled off, the higher the speed, the better the bonding force is. × means that the bonding force is very small and cannot be tested.

**Table 3 Properties of Conductive Films**

| | Mois ture conte nt (ppm ) | Bond ing layer (nm) | Proc ess laye r (nm ) | Transi tion layer (nm) | Functi onal layer (nm) | Protec tive layer (nm) | Den sity (%) | Bondi ng force (mm/ min) | Conduc tivity (1/m Ω) | Cost (RMB /m2 ) |
|---|---|---|---|---|---|---|---|---|---|---|
| Embodi ment 1 | 2152 | / | 21 | 12 | 1031 | 32 | 71 | 2 | 1/18 | A |
| Embodi ment 2 | 332.5 | / | 20 | 13 | 1033 | 30 | 74 | 6 | 1/18 | A |
| Embodi ment 3 | 2152 | / | 22 | 11 | 1035 | 35 | 71 | 4 | 1/18 | A |
| Embodi ment 4 | 2152 | / | 20 | 19 | 1034 | 33 | 87 | 3 | 1/18 | A |
| Embodi ment 5 | 2152 | / | 21 | 6 | 1031 | 34 | 61 | 3 | 1/19 | 1.1A |
| Embodi ment 6 | 332.5 | 15 | 24 | 14 | 1041 | 31 | 76 | 8 | 1/18 | 1.4A |
| Embodi ment 7 | 332.5 | 14 | 23 | 13 | 1040 | 32 | 78 | 8 | 1/18 | 1.4A |
| Embodi ment 8 | 2152 | 13 | 22 | 15 | 1046 | 29 | 84 | 6 | 1/18 | 1.2A |
| Compar ative Exampl e 1 | 2152 | / | 25 | / | 1039 | 33 | 43 | 3 | 1/24 | 0.8A |
| Compar ative Exampl e 2 | 2152 | / | / | 11 | 1042 | 34 | 30 | 4 | 1/20 | 0.8A |

It can be seen from Table 1 by comparing Embodiment 1 to Embodiment 8 and Comparative Example 1 to Comparative Example 2 that, without forming a process layer or without forming a transition layer, the cost of preparing the thermally conductive film is reduced, but the obtained thermally conductive film has a low density, and a poor conductivity, which cannot meet the requirements of some devices for a conductive film.

Comparing Embodiment 1 with Embodiment 2, it can be seen that in the case where no bonding layer is formed, baking the PP film to reduce the moisture content of the PP film can effectively increase the bonding force of the conductive film, and other properties of the conductive film will almost not be adversely affected.

Comparing Embodiment 1 with Embodiment 3, it can be seen that in the case where a transition layer is formed by magnetron sputtering, no matter whether the functional layer is formed by wet electroplating or by evaporation deposition, the density of the conductive film will not be affected, but if the functional layer is formed by evaporation deposition, the bonding force of the conductive film will increase to a certain extent.

Comparing Embodiment 1 with Embodiment 4, it can be seen that the increase in the thickness of the transition layer can effectively increase the density of the conductive film, and other properties will not be affected largely.

Comparing Embodiment 1 with Embodiment 5, it can be seen that the decrease in the thickness of the transition layer reduces not only the density of the conductive layer but also the conductivity of the conductive film, and increases the manufacturing cost of the conductive film.

Comparing Embodiment 2 with Embodiment 6, it can be seen that when the PP film is baked to reduce the moisture content of the PP film and a bonding layer is formed, the density of the conductive film can be further increased, and its bonding force can be effectively improved. Accordingly, its manufacturing cost will increase to a certain extent, but it can be used in the production of some devices with high requirements on conductive films.

Comparing Embodiment 6 with Embodiment 7, it can be seen that when copper is used as the bonding layer and the material of the bonding layer is the same as the material of the process layer, the transition layer and the functional layer, the density of the composite conductive film material is better, but the bonding force of the copper bonding layer is slightly poor.

Comparing Embodiment 7 with Embodiment 8, it can be seen that even if the copper bonding layer is used, without baking the PP film, the bonding force of the obtained composite conductive film material is poor. That is to say, when only the bonding layer is provided, the bonding force of the conductive film is slightly affected. When not only the moisture content of the insulating layer is controlled but also the bonding layer is provided, the bonding force of the conductive film can be better.

The above description is only some of the embodiments of the present disclosure, and it is not intended to limit the present disclosure. For those skilled in the art, the present disclosure may have various modifications and variations. Any modification, equivalent replacement, improvement, etc. made within the spirit and principle of the present disclosure shall be included within the protection scope of the present disclosure.

### Industrial Applicability

In the present disclosure, through the design of the metal process layer, the metal transition layer and the metal functional layer, the density and conductivity of the conductive film are both better while the thickness of the metal conductive layer can be guaranteed. The problem in the related art is solved that the density and conductivity of the composite conductive film will be reduced when ensuring its thickness. The composite conductive film material in the present disclosure has been significantly improved in terms of density and conductivity, has a very high industrial application value, and is suitable for promotion and application.

## Claims

1. A preparation method for a conductive film, comprising:
forming a metal process layer on a surface of an insulating layer by means of evaporation deposition, wet electroplating or chemical plating;
forming a metal transition layer on a surface of the metal process layer facing away from the insulating layer by means of magnetron sputtering; and
forming a metal functional layer on a surface of the metal transition layer facing away from the metal process layer.

2. The preparation method according to claim 1, wherein the metal functional layer is formed on the surface of the metal transition layer facing away from the metal process layer by means of wet electroplating.

3. The preparation method according to claim 1 or 2, further comprising, prior to said forming the metal process layer, preprocessing the insulating layer to make the insulating layer have a moisture content less than 1000 ppm.

4. The preparation method according to claim 3, wherein the preprocessing is performed by baking.

5. A conductive film obtained by the preparation method for the conductive film according to any one of claims 1 to 4.

6. The conductive film according to claim 5, wherein the conductive film has a density greater than 60%.

7. The conductive film according to claim 5, wherein the metal process layer is at least one selected from a copper metal layer, a nickel metal layer, an aluminum metal layer, a titanium metal layer, or an alloy layer.

8. The conductive film according to claim 5 or 7, wherein the metal transition layer is at least one selected from a copper metal layer, a nickel metal layer, an aluminum metal layer, a titanium metal layer, or an alloy layer.

9. The conductive film according to any one of claims 5 to 8, wherein the metal functional layer is at least one selected from a copper metal layer, a nickel metal layer, an aluminum metal layer, a titanium metal layer, or an alloy layer.

10. The conductive film according to any one of claims 5 to 9, wherein the metal process layer, the metal transition layer, and the metal functional layer are all copper layers.

11. The conductive film according to any one of claims 5 to 10, wherein the metal process layer has a thickness between 2 nm and 100 nm, the metal transition layer has a thickness between 5 nm to 50 nm, and the metal functional layer has a thickness between 30 nm and 2500 nm; and
optionally, the thickness of the metal functional layer is between 300 nm and 1500 nm.

12. The conductive film according to any one of claims 5 to 11, further comprising a bonding layer disposed between the insulating layer and the metal process layer, wherein
optionally, the bonding layer has a thickness between 2 nm and 40 nm; and
optionally, the bonding layer is a metal material layer comprising one or more of a Ti metal layer, a W metal layer, a Cr metal layer, a Ni metal layer, a Cu metal layer, or an alloy layer thereof.

13. The conductive film according to any one of claims 5 to 12, further comprising a protective layer disposed on a surface of the metal functional layer facing away from the metal transition layer, wherein
optionally, the protective layer has a thickness between 0.1 nm and 100 nm; and
optionally, the protective layer is a conductive non-metallic protective layer or an inert metal protective layer.

14. A composite conductive film material, comprising an insulating layer and a conductive layer disposed on a surface of the insulating layer, wherein the conductive layer is the conductive film according to any one of claims 5 to 13.

15. The composite conductive film material according to claim 14, wherein the insulating layer has a moisture content smaller than 1000 ppm.

16. A preparation method for the composite conductive film material according to claim 14 or 15, comprising: forming the conductive layer on the surface of the insulating layer.

17. The preparation method for the composite conductive film material according to claim 16, further comprising, prior to said forming the conductive layer on the surface of the insulating layer, preprocessing the insulating layer to make the insulating layer have a moisture content smaller than 1000 ppm, wherein
optionally, the preprocessing is performed by baking.
